(19) **Europäisches Patentamt / European Patent Office / Office européen des brevets**

(11) **EP 2 414 850 B1**

(12) **FASCICULE DE BREVET EUROPEEN**

(45) Date de publication et mention
de la délivrance du brevet:
**10.02.2016 Bulletin 2016/06**

(21) Numéro de dépôt: **10717686.9**

(22) Date de dépôt: **30.03.2010**

(51) Int Cl.:
*G01R 31/00* (2006.01)    *G01R 29/08* (2006.01)

(86) Numéro de dépôt international:
**PCT/FR2010/050594**

(87) Numéro de publication internationale:
**WO 2010/112763 (07.10.2010 Gazette 2010/40)**

(54) **PROCÉDÉ DE CONTRÔLE DE LA DIRECTIVITÉ ET LA POLARISATION DE DISTRIBUTIONS COHÉRENTES DE CHAMP DANS UN MILIEU RÉVERBÉRANT**

VERFAHREN ZUM PRÜFEN DER AUSRICHTUNG UND POLARISATION VON KOHÄRENTEN FELDVERTEILUNGEN IN EINEM REFLEKTIVEN MEDIUM

METHOD OF CHECKING THE DIRECTIVITY AND POLARIZATION OF COHERENT FIELD DISTRIBUTIONS IN A REVERBERANT MEDIUM

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**
Etats d'extension désignés:
**AL BA ME RS**

(30) Priorité: **30.03.2009 FR 0951995**

(43) Date de publication de la demande:
**08.02.2012 Bulletin 2012/06**

(73) Titulaire: **SUPELEC**
**91192 Gif sur Yvette (FR)**

(72) Inventeurs:
• **COZZA, Andrea**
 **F-75014 Paris (FR)**
• **MOUSSA, Mouhamad, Houmam**
 **F-77000 MELUN (FR)**

(74) Mandataire: **Pontet Allano & Associes**
**Parc Les Algorithmes, Bâtiment Platon**
**CS 70003 Saint-Aubin**
**91192 Gif-sur-Yvette Cedex (FR)**

(56) Documents cités:
**WO-A-2005/104473    US-A- 4 864 315**
**US-A- 5 302 960**

• **CHRISTOPHER L HOLLOWAY ET AL: "On the Use of Reverberation Chambers to Simulate a Rician Radio Environment for the Testing of Wireless Devices" IEEE TRANSACTIONS ON ANTENNAS AND PROPAGATION, IEEE SERVICE CENTER, PISCATAWAY, NJ, US, vol. 54, no. 11, 1 novembre 2006 (2006-11-01), pages 3167-3177, XP011150298 ISSN: 0018-926X**

**EP 2 414 850 B1**

## Description

La présente invention se rapporte à un procédé de génération d'un champ spatio-temporel dans un milieu réverbérant pour analyser le comportement d'un objet sous test disposé dans le milieu réverbérant. Elle trouve une application particulièrement intéressante dans la mise en évidence de défauts d'immunité d'objets soumis à des émissions électromagnétiques ou encore dans la réponse d'objets soumis à un champ particulier. La présente invention peut également s'appliquer dans le domaine acoustique.

D'une façon générale, avec l'augmentation du nombre d'équipements électroniques dans les systèmes actuels, il devient indispensable de vérifier leur susceptibilité aux émissions rayonnées.

Pour assurer le fonctionnement simultané de ces équipements à proximité les uns des autres il faut vérifier leur aptitude à fonctionner dans leur environnement de façon satisfaisante sans produire de perturbations intolérables pour tout ce qui se trouve dans cet environnement. Il en ressort une nécessité d'étude de la réponse d'un objet soumis à un champ, que ce soit un composant, un équipement ou un système complet, pour déterminer des voies d'accès privilégiées aux agressions extérieures et parer ces défauts.

Aussi, obtenir des niveaux de champ élevés dans le domaine des radiofréquences tout en maintenant le coût des instruments de mesure le plus faible possible est devenue une priorité pour les industriels. Ces derniers sont tenus de vérifier que les nouveaux produits qu'ils proposent répondent à des normes de compatibilité et nécessitent de nombreux tests.

Cependant, ces tests peuvent être coûteux en termes de temps d'immobilisation de système, ce qui se traduit par une perte économique sur le lancement d'une chaine de production ou encore en termes d'instrumentation et de puissance à mettre en oeuvre pour réaliser ces tests.

Ainsi on peut être amené à soumettre l'objet sous test à des ondes localement planes présentant des caractéristiques bien précises comme une direction de propagation et une polarisation comme cela est le cas pour les tests réalisés en chambre anéchoïque. Pour ce genre de tests directifs le nombre de configurations de test est rapidement limité, quelques directions d'arrivées sur l'objet sous test et deux polarisations (horizontale et verticale) sont utilisées pour minimiser la durée d'immobilisation des systèmes testés car le changement de configuration de façon mécanique prend un certain temps. Qui plus est, si l'on est intéressé à la génération d'un champ de forte intensité il faut mettre en jeu de fortes puissances qui entrainent un surcoût en termes d'équipement et de maintenance.

Une autre solution souvent utilisée dans l'art antérieur est la génération de champs intenses, isotropes et homogènes à l'aide de chambres réverbérantes à brassage de modes. Celles-ci permettent d'exciter simultanément un nombre considérable d'ondes localement planes provenant de directions aléatoires ainsi que différentes polarisations tout en assurant un niveau de champ moyen important à partir de puissances injectées relativement faibles. Toutefois elles présentent des inconvénients concernant la précision des mesures, dépendantes de la tolérance sur l'uniformité du champ ainsi que de par le caractère aléatoire des directions de propagation du champ et de ses polarisations excitées. En effet la nature aléatoire de l'agression, bien que capable de mettre en évidence la présence d'un défaut dans un système, ne permet pas d'en identifier précisément l'origine, ni l'emplacement, à moins de mettre en oeuvre des tests ultérieures dans une chambre anéchoïque.

On connaît le document WO 2005/104473 A1 décrivant la technique de retournement temporel d'une onde et vise la transmission de signaux suivant un modèle de communication sans fils point à point sans possibilité de contrôler la directivité ni la polarisation de la propagation du front d'onde.

En outre on connaît les documents suivants: US 4 864 315 A (MOHUCHY WOLODYMYR, 1989-09-05), CHRISTOPHER L HOLLOWAY ET AL: "On the Use of Reverberation Chambers to Simulate a Rician Radio Environment for the Testing of Wireless Devices" (IEEE TRANSACTIONS ON ANTENNAS AND PROPAGATION, IEEE SERVICE CENTER, PISCATAWAY, NJ, US, vol. 54, no. 11, 1 novembre 2006 (2006-11-01), pages 3167-3177) et US 5 302 960 A (BOERS PETER, 1994-04-12).

La présente invention a pour but de remédier aux inconvénients précités en proposant un procédé permettant de générer un champ intense et d'en contrôler la directivité, la direction d'arrivée et la polarisation. Un autre but de l'invention est un contrôle temps réel de la distribution spatio-temporel du champ produit.

On atteint au moins l'un des objectifs précités avec un procédé de génération d'un champ spatio-temporel dans un milieu réverbérant pour analyser le comportement d'un objet sous test disposé dans le milieu réverbérant. Le procédé selon l'invention comprend les étapes suivantes :

- on estime au moins une fonction de transfert entre un premier groupe de transducteurs comprenant au moins un transducteur disposé dans le milieu réverbérant et un second groupe de transducteurs comprenant au moins un transducteur également disposé dans le milieu réverbérant,
- en tenant compte de la répartition spatiale des transducteurs du premier groupe, on considère un champ spatio-temporel d'excitation que l'on souhaite appliquer sur l'objet,
- on modélise des signaux primaires qui, lorsque appliqués sur le premier groupe de transducteurs, permettraient d'obtenir ledit champ spatio-temporel d'excitation,
- on applique ladite au moins une fonction de transfert sur ces signaux primaires de façon à obtenir des signaux secondaires,

- on utilise une technique dite de retournement temporel dans le domaine temporel ou de conjugaison de phases dans le domaine fréquentiel sur ces signaux secondaires de façon à déterminer des signaux d'excitation, et
- on applique ces signaux d'excitation sur les transducteurs du second groupe de façon à obtenir ledit champ spatio-temporel d'excitation sur l'objet.

Le milieu réverbérant peut être une chambre réverbérante ou une enceinte avec une forte réflectivité des parois aux ondes incidentes.

On utilise donc le premier groupe de transducteurs pour l'estimation des fonctions de transfert. Par contre ce premier groupe n'est plus nécessaire lors de l'injection des signaux d'excitation, c'est-à-dire, par exemple, lors de mesures de compatibilité électromagnétique d'un objet sous test. En effet, une fois les fonctions de transfert déterminées, on peut réaliser de nombreux scénarii de propagation d'onde en modifiant uniquement les signaux d'excitation ; la position des transducteurs du second groupe restant identique à leur position lors de l'estimation.

Avec le procédé selon l'invention, on s'affranchit d'une phase d'apprentissage du parcours initial de l'onde et d'une focalisation de l'onde d'excitation uniquement sur une source d'émission, comme dans l'art antérieur. La présente invention permet de réaliser la génération de distributions spatiales cohérentes, de fortes intensités et polarisées du champ spatio-temporel dans un milieu réverbérant tout en conservant la possibilité de focaliser ce champ n'importe où dans le milieu réverbérant.

L'invention présente un sérieux avantage, par rapport à l'art antérieur, en ce qui concerne la durée des tests qui n'est limitée que par les limites physiques de l'environnement de test comme par exemple le temps de propagation du front d'onde que l'on génère. Ainsi, une durée de test représentative de 1ms permet de réaliser 1000 configurations différentes en une seconde à partir d'une seule et même phase initiale de caractérisation (obtention des fonctions de transfert pour un positionnement donné des transducteurs).

Selon une caractéristique avantageuse de l'invention, au cours de l'étape de modélisation, chaque signal primaire est défini sous la forme $\alpha_j.X$, où $X$ est le spectre fréquentiel d'un signal en fonction de la variation temporel que l'on souhaite obtenir ; $\alpha$ est un coefficient complexe de pondération en amplitude et en phase du signal $X$, et $j$ est un indice désignant chaque transducteur du premier groupe de transducteurs ; ces coefficients $\alpha_j$ étant définis en fonction de la directivité, et/ou la direction d'arrivée, et/ou l'intensité du champ spatio-temporel d'excitation, et/ou la polarisation.

De préférence, on détermine les $\alpha_j$ selon une technique de synthèse de réseau de transducteurs en espace libre. Plus précisément, lors de l'estimation de la fonction de transfert, il existe une fenêtre temporelle où le rayonnement des transducteurs du premier groupe se propage dans les conditions de l'espace libre durant laquelle le front d'onde émis n'a pas eu d'interaction avec les parois du milieu réverbérant. La technique de retournement (« Time Reversal » en langue anglaise) va permettre de retrouver cette fenêtre temporelle en transformant le front d'onde divergente en un front d'onde convergeant vers l'objet sous test.

En d'autres termes, la présente invention permet de considérer un champ spatio-temporel que l'on souhaite appliquer à l'objet sous test ; les propriétés de ce champ spatio-temporel comprenant notamment l'intensité, la polarisation, la directivité et la direction d'arrivée. Pour obtenir un tel champ spatio-temporel avec des propriétés données, on détermine le signal primaire qui devrait être appliqué sur chaque transducteur du premier groupe. En particulier, il s'agit d'un même signal primaire mais avec une pondération $\alpha_j$ différente sur chaque transducteur du premier groupe. Connaissant la fonction de transfert entre les transducteurs du premier groupe et du second groupe, on détermine des signaux secondaires qui seraient captés par les seconds transducteurs pour une émission divergente du champ spatio-temporel depuis les transducteurs du premier groupe. Cela se fait par simulation du rayonnement divergent du champ spatio-temporel en espace libre à l'aide de modèles analytiques ou numériques. La technique de retournement permet ensuite de déterminer le signal d'excitation (pondéré par transducteur) à appliquer réellement sur les transducteurs du second groupe de façon à obtenir un champ spatio-temporel d'excitation convergeant vers l'objet sous test, les propriétés de ce champ spatio-temporel d'excitation étant identiques à celles du champ spatio-temporel divergent ci-dessus.

Avantageusement, au cours de l'étape d'estimation d'au moins une fonction de transfert, on peut déterminer deux fonctions de transfert pour respectivement deux orientations orthogonales différentes dudit au moins un transducteur du premier groupe de transducteurs ; les deux orientations étant tangentes à une surface comprenant l'ensemble des transducteurs du premier groupe de transducteurs ; puis à l'étape de modélisation, on applique une combinaison linéaire des deux fonctions de transfert en fonction de la polarisation souhaitée du front d'onde dudit champ spatio-temporel d'excitation. On peut ainsi définir tout type de polarisation pour le champ spatio-temporel d'excitation, comme par exemple une polarisation linéaire. De préférence, au cours de la première phase, on détermine trois fonctions de transfert pour respectivement trois orientations orthogonales différentes dudit au moins un transducteur du premier groupe de transducteurs ; puis à l'étape de modélisation, on applique une combinaison linéaire des trois fonctions de transfert en fonction de la polarisation souhaitée du front d'onde dudit champ spatio-temporel d'excitation. Comme dans le cas de deux orientations tangentes, on peut également définir tout type de polarisation pour le champ spatio-temporel d'excitation.

Avec un tel procédé selon l'invention, le champ spatio-temporel d'excitation présente un front d'onde dont les propriétés peuvent être facilement et rapidement modifiées :

- la directivité : on peut modifier en temps réel la directivité du front d'onde sans déplacement mécanique et/ou électronique des transducteurs du second groupe, il suffit de changer les signaux appliqués sur ces transducteurs ; il en est de même de la direction d'arrivée du front d'onde qui, elle, est notamment liée à la disposition des transducteurs du premier groupe ;
- la polarisation : à partir de l'orthogonalité, soit de trois fonctions de transfert dans trois directions principales orthogonales x,y,z, soit de deux fonctions de transfert avec des orientations tangentes comme vu précédemment, on peut adresser n'importe quelle polarisation issue de la combinaison linéaire de ces trois fonctions de transfert ;
- déplacement du centre de phase de l'onde convergente : permet d'aller focaliser un champ sur une partie précise de l'objet sous test.

Avantageusement, le premier groupe de transducteurs peut comprendre une pluralité de transducteurs disposés :

- de façon linéaire,
- de façon surfacique,
- de façon à constituer un volume autour de l'objet sous test, par exemple en suivant la forme de l'objet.

Selon un mode de réalisation avantageux de l'invention, les transducteurs, en particulier ceux du premier groupe, sont le moins intrusifs possible. En fait, il s'agit de composants capables de convertir un signal électromagnétique ou acoustique en un signal électrique ou optique. Chaque transducteur du premier groupe peut être une antenne ou sonde capable d'émettre un champ spatio-temporel lors de la détermination de la fonction de transfert, mais capable d'être « invisible » lors des phases de mesure. Par invisible, on entend le moins perturbateur possible par rapport au champ spatio-temporel d'excitation généré par les transducteurs du second groupe. Avantageusement, les transducteurs du premier groupe peuvent être des sondes électro-optiques ou électro-acoustiques.

Les sondes électro-optiques peuvent être à base de cristaux électro-optiques. Il ne s'agit pas réellement d'antennes. Une telle sonde électro-optique fonctionne de telle sorte que le signal associé à un champ capté par cette sonde module un signal optique qui est ensuite transmis par fibre optique vers une unité de traitement. A partir de cette modulation on estime le champ à l'endroit de la sonde.

On peut également utiliser des sondes électro-optiques basées sur une conversion RF/optique. Dans ce cas, il y a une antenne qui fait office de sonde et un module de conversion RF/optique. Le signal capté est converti puis transmis sur fibre optique. Une variante de telles sondes est l'utilisation, à la place de l'antenne, d'un capteur de champ électrique ou magnétique (cellules TEM, capacités, capteurs à effet Hall, etc.).

Selon un mode de réalisation de l'invention, au cours de l'étape d'estimation d'au moins une fonction de transfert, on peut utiliser au moins un transducteur du premier groupe que l'on déplace dans différentes positions, on détermine une composante de ladite au moins une fonction de transfert pour chaque position différente. En d'autres termes, plutôt que d'avoir un réseau de transducteurs du premier groupe, on n'utilise par exemple qu'un seul transducteur que l'on déplace de façon à déterminer la fonction de transfert globale.

A titre d'exemple, l'estimation de ladite au moins une fonction de transfert est obtenue dans le domaine fréquentiel en utilisant un analyseur de réseaux, notamment vectoriel. Autrement, l'estimation de ladite au moins une fonction de transfert peut être obtenue dans le domaine temporel en utilisant un générateur de fonctions ou de formes d'ondes arbitraires et un oscilloscope.

D'autres avantages et caractéristiques de l'invention apparaîtront à l'examen de la description détaillée d'un mode de mise en oeuvre nullement limitatif, et des dessins annexés, sur lesquels :

- La figure 1 est un schéma simplifié d'une configuration pour la caractérisation du milieu réverbérant de façon à déterminer des fonctions de transfert $H_{ij}$ ; et
- La figure 2 est un schéma simplifié d'une phase de mesure au cours de laquelle on injecte des signaux d'excitation dans des transducteurs du second groupe désigné par Réseau de Synthèse de Champ (RSC).

Bien que l'invention n'y soit pas limitée, on va maintenant décrire le procédé selon l'invention pour des mesures de compatibilité électromagnétique d'un équipement sous test (EST) placé dans une chambre réverbérante.

La mise en oeuvre de ce procédé nécessite un environnement fortement réverbérant comme par exemple une enceinte de forme quelconque dont les parois présentent une forte réflectivité et par conséquent introduisent le moins de pertes possibles. L'invention permet de générer des champs intenses, déterministes et cohérents dans une enceinte réverbérante habituellement utilisée pour générer des champs intenses, mais aléatoires et non cohérents.

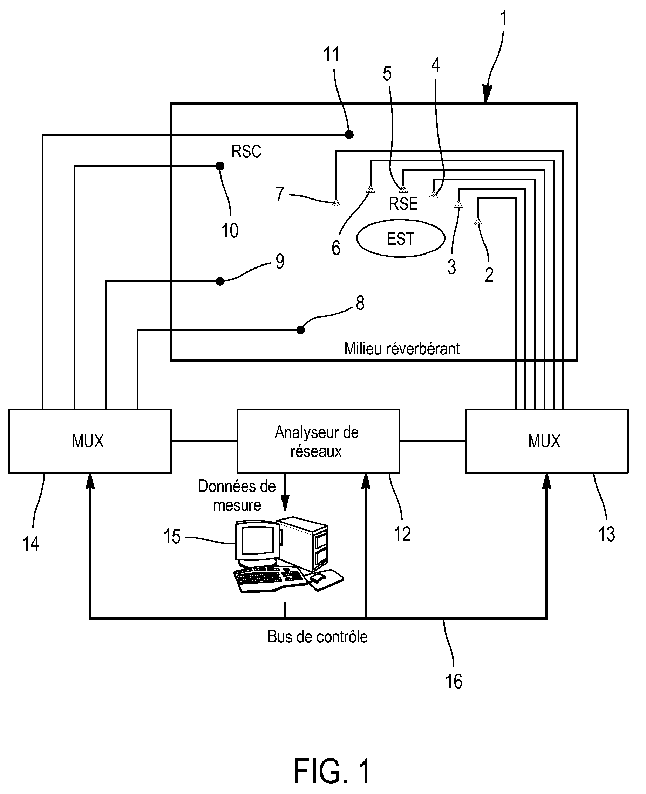

Sur la figure 1, on voit une configuration pour caractériser le milieu réverbérant contenu dans une chambre 1. On distingue une collection de transducteurs permettant la génération ou la mesure du champ et que l'on peut répartir en deux familles distinctes :

- un premier groupe de six transducteurs 2-7 qui définissent un Réseau de Sources Equivalentes (RSE) dont la surface correspondant à leur distribution dans le milieu réverbérant ; le RSE émule le rayonnement d'une source ponctuelle au centre de l'équipement sous test (EST) ;
- un second groupe de quatre transducteurs 8-11 qui définissent un Réseau de Synthèse du Champ (RSC) et qui peuvent être disposés sur les parois ou dans tout le volume du milieu réverbérant.

Selon l'invention, on peut disposer des diffuseurs passifs du champ (non représentés) afin d'améliorer éventuellement les performances, mais cela introduit un niveau de complexité supplémentaire.

L'équipement sous test EST peut être, de façon préférentielle, présent pendant toute la durée du test. Le but d'une mesure de compatibilité électromagnétique est d'agresser l'équipement sous test EST avec des fronts d'ondes cohérents (impulsionnels ou non) selon des directions d'arrivée différentes. Donc, en fonction de l'ensemble des directions que l'on envisage, on définit la configuration spatiale du réseau de sources équivalentes RSE.

Par exemple, si l'on souhaite tester l'équipement sous test EST sur un seul côté, il suffit de définir un réseau de sources équivalentes RSE surfacique, comme sur la figure 1. Les transducteurs 2-7 du RSE sont disposés proches de l'équipement sous test EST selon une surface concave qui entoure partiellement l'équipement sous test EST. Cette disposition est déterminée de façon à générer un front d'onde venant heurter l'équipement sous test EST dans le sens Nord-Sud, depuis le réseau RSE vers l'équipement sous test EST, en un point de focalisation.

Dans le cas où toutes les directions sont à considérer, le réseau de sources équivalentes RSE décrira une surface fermée formant un volume qui contiendra l'équipement sous test EST.

Les degrés de libertés sur ces configurations sont multiples comme :

- la largeur transversale du support (extension spatiale) de l'onde qui impacte (large/mince) ou focalisation très localisée,
- les différents angles d'élévations et azimutaux du front d'onde généré,
- différentes polarisations, linéaires, elliptiques, et
- différentes formes d'ondes temporelles.

Le procédé selon l'invention comprend une étape d'estimation d'une fonction de transfert permettant ainsi de caractériser le milieu réverbérant. On détermine des fonctions de transferts $H_{ij}(\omega)$ entre chaque élément i du Réseau de Synthèse du Champ RSC et chaque élément j du réseau de sources équivalentes RSE. Ces fonctions peuvent être mesurées dans le temps ou en fréquence avec des dispositifs adaptés (Oscilloscope, analyseur de réseau vectoriel,...). Sur la figure 1 on utilise un analyseur de réseaux 12 relié d'une part à un premier multiplexeur 13 qui est connecté à l'ensemble des transducteurs 2-7 du réseau de sources équivalentes RSE, et d'une autre part à un second multiplexeur 14 qui est connecté aux quatre transducteurs 8-11 du Réseau de Synthèse du Champ RSC. Les données de mesure provenant de l'analyseur de réseaux 12 sont collectées puis traitées par une unité de traitement 15 telle qu'un micro-ordinateur doté de capacité et de composants nécessaires pour réaliser des traitements numériques. Un bus de contrôle 16 est utilisé pour que l'unité de traitement 15 communique avec les deux multiplexeurs 13 et 14 et l'analyseur de réseaux.

Le système étant réciproque, on peut soit exciter le milieu réverbérant en appliquant un signal de forme temporelle quelconque par les transducteurs (antennes) 2-7 du réseau de sources équivalentes RSE une à une puis collecter les signaux sur les différents transducteurs (antennes) 8-11 du Réseau de Synthèse du Champ RSC, soit exciter une à une les transducteurs (antennes) du Réseau de Synthèse du Champ RSC et mesurer sur celles du réseau de sources équivalentes RSE. En effet, si on injecte un signal, $X(\omega)$ (qui peut être une gaussienne ou un balayage en fréquence à l'aide de sinusoïdes), présentant une bande passante spectrale non nulle sur une antenne i du Réseau de Synthèse du Champ RSC on obtient sur une antenne j du réseau de sources équivalentes RSE :

$$Y_j(\omega) = X(\omega)H_{ij}(\omega).$$

De même si on excite par les antennes du RSE on obtient les signaux suivants sur les antennes du RSC. Par exemple si on excite par l'antenne j du RSE l'antenne reçoit :

$$Y_i(\omega) = X(\omega)H_{ji}(\omega).$$

On recommence ce processus jusqu'à déterminer la matrice H(w) qui contient l'ensemble des fonctions de transfert reliant les deux collections de transducteurs, et pour une configuration spécifique du réseau de sources équivalentes RSE et du réseau de synthèse du champ RSC.

On peut alors réitérer ce processus plusieurs fois pour obtenir des fonctions de transferts associées aux trois polarisations principales x,y et z dans un repère cartésien en changeant l'orientation des éléments du réseau de sources équivalentes RSE lors de la mesure. On obtient alors trois jeux de fonctions de transferts orthogonaux entre eux, $H_{ij\_x}(\omega)$, $H_{ij\_y}(\omega)$, $H_{ij\_z}(\omega)$, qui constituent une base génératrice de ces trois polarisations principales et de toutes combinaisons linéaires de celles-ci.

Il est maintenant possible de créer plusieurs types d'agression, avec la possibilité de choisir sa distribution spatio-temporelle et sa polarisation. Toutefois, le choix des directions d'impact est fonction de la configuration choisie pour les transducteurs 2-7. Avec une configuration sphérique des transducteurs 2-7 autour de l'EST, il est possible d'envisager tout type d'agression selon toutes les directions possibles sur 360°.

Pour pouvoir paramétrer le champ spatio-temporel, on associe deux quantités à la matrice H, c'est-à-dire un signal temporel x(t) (ou X(ω) dans le domaine fréquentiel) qui définit l'évolution temporelle du front d'onde du champ spatio-temporel à impacter sur l'équipement de test EST, et les poids $\alpha_j$, qui définissent surtout l'évolution spatiale du front d'onde. Les poids $\alpha_j$ permettent de fixer la direction et la directivité du front d'onde du champ spatio-temporel devant heurter l'EST.

Le signal x(t) est défini par rapport aux fréquences pour lesquelles on envisage d'agresser l'équipement sous test EST, donc il est principalement défini par rapport à une bande passante et une fréquence centrale. Néanmoins, il existe une infinité de signaux qui partage la même occupation de fréquences. Donc, on définit également le type de signal, par exemple s'il s'agit d'une impulsion gaussienne, ou d'une porte rectangulaire, ou trapézoïdale, etc.

Les poids $\alpha_j$ sont définis à partir de la considération suivante : le front d'onde qui sera reconstruit grâce au retournement temporel, et se dirigeant sur l'équipement sous test EST (à travers la surface identifiée par le réseau de sources équivalentes RSE) aura les mêmes caractéristiques spatio-temporelles du front d'onde qui aurait été généré par les transducteurs du réseau de sources équivalentes RSE, si ces derniers étaient excités par le signal x(t) et pondérés par les poids $\alpha_j$. La seule différence sera que dans le cas du réseau de sources équivalentes RSE qui émet, le front d'onde se propagera vers l'extérieur (divergent), plutôt que vers (convergent) l'équipement sous test EST. Cette considération implique que les poids $\alpha_j$ sont choisis en fonction du front d'onde que l'on souhaite utiliser pour tester l'équipement sous test EST, mais ils ne seront pas définis dans la configuration finale d'utilisation, mais plutôt dans une configuration où ce serait le réseau de sources équivalentes RSE qui émettrait le front d'onde en espace libre, sans la présence du milieu réverbérant. Cette étape est alors indépendante de la phase de caractérisation, et elle peut être réalisée grâce aux techniques de synthèse de réseau de transducteurs en espace libre.

Comme vu précédemment, pour pouvoir contrôler la polarisation du front d'onde, il est nécessaire de mesurer la matrice H pour différentes orientations des transducteurs du RSE. Dans ce cas, différents jeux de poids $\alpha_j$ sont à considérer, un jeu pour chaque composante de la polarisation que l'on souhaite modifier/exciter.

Ayant caractérisé le milieu, et ayant fixé le signal d'excitation x(t) et les différents jeux de poids $\alpha_j$, on peut alors synthétiser des signaux d'excitation $y_i(t)$ qui seront appliqués aux transducteurs du RSC, grâce à l'utilisation de la formule de retournement suivante :

$$y_i(t) = \mathsf{F}^{-1}\left\{ X^*(\omega) \sum_j \alpha_j^* H_{ij}^*(\omega) \right\}$$

où l'étoile représente l'opération de conjugaison complexe, X(ω) et $H_{ij}(\omega)$ étant définies dans le domaine fréquentiel. L'opérateur $\mathsf{F}^{-1}$ est la transformée inverse de Fourier (ou, d'une façon équivalente, celle de Laplace).

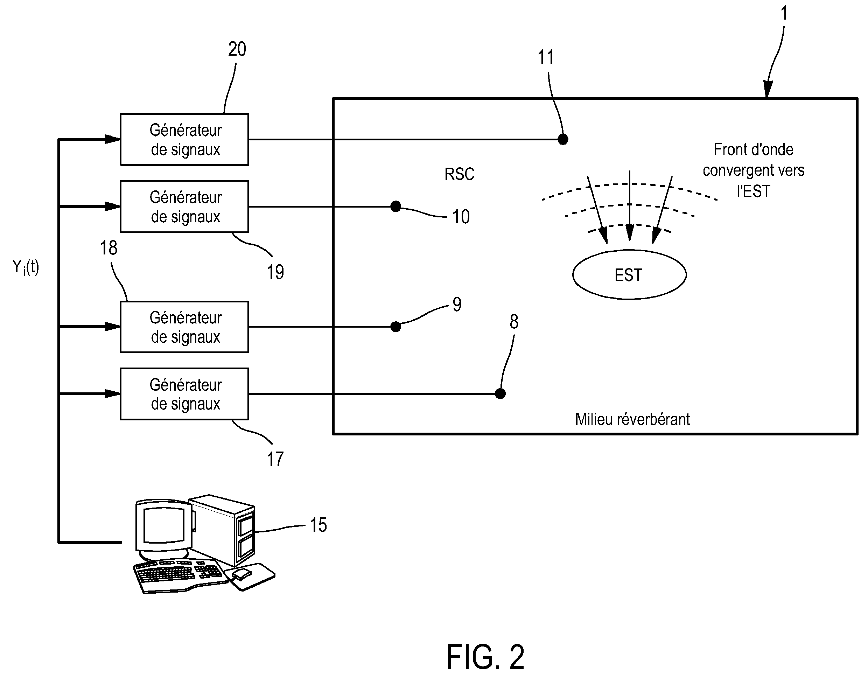

A part la phase de caractérisation du milieu réverbérant, toutes les autres étapes ci-dessus sont réalisées par traitement numérique au moyen de l'ordinateur 15 ou grâce à des résultats calculés préalablement. La synthèse des signaux d'excitation $y_i(t)$ accomplie, ceux-ci sont appliqués aux transducteurs 8-11 du réseau de synthèse du champ RSC, et générés dans le domaine temporel conformément à la figure 2. On retrouve sur cette figure 2 la chambre réverbérante 1 comprenant les mêmes éléments que sur la figure 1, mais les transducteurs 2-7 ont été retirés pour la phase de génération de fronts d'onde. Mais on peut tout à fait envisager de les laisser dans la chambre. Dans ce cas, ces transducteurs 2-7 sont de préférence choisis de façon à ne pas perturber la phase d'injection des signaux d'excitation.

Pour générer les signaux d'excitation $y_i(t)$, on utilise, pour chaque transducteur du réseau de synthèse du champ RSC, un générateur 17 ,..., 20 de formes d'ondes arbitraires en bande base, en appliquant successivement une modulation pour décaler le spectre du signal autour de la porteuse (ou fréquence centrale) choisie lors de la détermination du signal primaire x(t). D'autres techniques équivalentes existent, comme l'utilisation de modulateur I/Q. Les signaux ainsi injectés dans le milieu réverbérant reconstitue un front d'onde cohérent qui impacte sur l'équipement sous test EST selon la direction, l'intensité, la directivité et la polarisation telles que prédéfinies par les x(t) et les poids $\alpha_j$, voir les flèches sur la figure 2.

Ensuite, si l'on souhaite générer un front d'onde différent, avec une distribution spatiale différente, une évolution temporelle différente (signal x(t)) ou une polarisation différente, il suffit de déterminer de nouveaux signaux d'excitation $y_i(t)$ à partir d'un nouveau signal x(t) et de nouveaux poids $\alpha_j$, sans avoir besoin de caractériser à nouveau le milieu réverbérant. On peut tester l'équipement sous test EST sous différentes directions d'impacte, polarisation, et variations temporelles en succession très rapide. La limitation principale sera donnée par les temps de calcul de l'ordinateur 15 qui synthétise les signaux $y_i(t)$. La présente invention permet donc de contrôler en temps réels les propriétés du champ spatio-temporel dans une enceinte réverbérante.

La présente invention peut avantageusement s'appliquer à des tests :

- de susceptibilité et/ou immunité électromagnétique,
- d'efficacité de blindage aux émissions rayonnées,
- de mise en évidence d'effets non linéaires ou de test champ de claquage sur un objet soumis à un champ, et
- de détermination d'une section radar (Acoustique et Electromagnétisme).

Bien sûr, l'invention n'est pas limitée aux exemples qui viennent d'être décrits et de nombreux aménagements peuvent être apportés à ces exemples sans sortir du cadre de l'invention.

## Revendications

1. Procédé de génération d'un champ spatio-temporel dans un milieu réverbérant pour analyser le comportement d'un objet sous test disposé dans le milieu réverbérant, **caractérisé en ce qu'**il comprend les étapes suivantes :

   - on estime au moins une fonction de transfert entre un premier groupe de transducteurs comprenant au moins un transducteur disposé dans le milieu réverbérant et un second groupe de transducteurs comprenant au moins un transducteur également disposé dans le milieu réverbérant,
   - en tenant compte de la répartition spatiale des transducteurs du premier groupe, on considère un champ spatio-temporel d'excitation que l'on souhaite appliquer sur l'objet,
   - on modélise des signaux primaires qui, lorsque appliqués sur le premier groupe de transducteurs, permettraient d'obtenir ledit champ spatio-temporel d'excitation,
   - on applique ladite au moins une fonction de transfert sur ces signaux primaires de façon à obtenir des signaux secondaires,
   - on utilise une technique dite de retournement temporel dans le domaine temporel ou de conjugaison de phases dans le domaine fréquentiel sur ces signaux secondaires de façon à déterminer des signaux d'excitation, et
   - on applique ces signaux d'excitation sur les transducteurs du second groupe de façon à obtenir ledit champ spatio-temporel d'excitation sur l'objet.

2. Procédé selon la revendication 1, **caractérisé en ce qu'**au cours de l'étape de modélisation, chaque signal primaire est défini sous la forme $\alpha_j.X$, où $X$ est le spectre fréquentiel d'un signal en fonction de la variation temporel que l'on souhaite obtenir ; $\alpha$ est un coefficient complexe de pondération en amplitude et en phase du signal $X$, et $j$ est un indice désignant chaque transducteur du premier groupe de transducteurs ; ces coefficients $\alpha$ étant définis en fonction de la directivité, direction d'arrivée, polarisation et/ou l'intensité du champ spatio-temporel d'excitation.

3. Procédé selon la revendication 1 ou 2, **caractérisé en ce qu'**on détermine les $\alpha_j$ selon une technique de synthèse de réseau de transducteurs en espace libre.

4. Procédé selon l'une quelconque des revendications précédentes, **caractérisé en ce qu'**au cours de l'étape d'estimation d'au moins une fonction de transfert, on détermine deux fonctions de transfert pour respectivement deux orientations orthogonales différentes dudit au moins un transducteur du premier groupe de transducteurs ; les deux orientations étant tangentes à une surface comprenant l'ensemble des transducteurs du premier groupe de transducteurs ; puis à l'étape de modélisation, on applique une combinaison linéaire des deux fonctions de transfert en fonction de la polarisation souhaitée du front d'onde dudit champ spatio-temporel d'excitation.

5. Procédé selon l'une quelconque des revendications 1 à 3, **caractérisé en ce qu'**au cours de la première phase, on détermine trois fonctions de transfert pour respectivement trois orientations orthogonales différentes dudit au moins un transducteur du premier groupe de transducteurs ; puis à l'étape de modélisation, on applique une combinaison linéaire des trois fonctions de transfert en fonction de la polarisation souhaitée du front d'onde dudit champ spatio-temporel d'excitation.

6. Procédé selon l'une quelconque des revendications précédentes, **caractérisé en ce que** le premier groupe de transducteurs comprend une pluralité de transducteurs disposés de façon linéaire.

7. Procédé selon l'une quelconque des revendications 1 à 5, **caractérisé en ce que** le premier groupe de transducteurs comprend une pluralité de transducteurs disposés de façon surfacique.

8. Procédé selon l'une quelconque des revendications 1 à 5, **caractérisé en ce que** le premier groupe de transducteurs comprend une pluralité de transducteurs disposés de façon à constituer un volume autour de l'objet sous test.

9. Procédé selon l'une quelconque des revendications précédentes, **caractérisé en ce que** les transducteurs du premier groupe de transducteurs sont des sondes électro-optiques.

**10.** Procédé selon l'une quelconque des revendications 1 à 8, **caractérisé en ce que** les transducteurs du premier groupe de transducteurs sont des sondes électro-acoustiques.

**11.** Procédé selon l'une quelconque des revendications précédentes, **caractérisé en ce qu'**au cours de l'étape d'estimation d'au moins une fonction de transfert, on utilise au moins un transducteur du premier groupe que l'on déplace dans différentes positions, on détermine une composante de ladite au moins une fonction de transfert pour chaque position différente.

**12.** Procédé selon l'une quelconque des revendications précédentes, **caractérisé en ce que** l'estimation de ladite au moins une fonction de transfert est obtenue dans le domaine fréquentiel en utilisant un analyseur de réseaux.

**13.** Procédé selon l'une quelconque des revendications 1 à 11, **caractérisé en ce que** l'estimation de ladite au moins une fonction de transfert est obtenue dans le domaine temporel en utilisant un générateur de fonctions ou de formes d'ondes arbitraires et un oscilloscope.

**Patentansprüche**

**1.** Verfahren zur Erzeugung eines räumlich-zeitlichen Felds in einem reflektiven Medium, um das Verhalten eines in dem reflektiven Medium gelagerten Gegenstands unter Test zu untersuchen, **dadurch gekennzeichnet, dass** es folgende Schritte umfasst:

    - es wird mindestens eine Übertragungsfunktion zwischen einer ersten, mindestens einen im reflektiven Medium gelagerten Transduktor umfassenden Transduktorengruppe und einer zweiten, mindestens einen ebenfalls im reflektiven Medium gelagerten Transduktor umfassenden Transduktorengruppe geschätzt,
    - es wird unter Berücksichtigung der räumlichen Verteilung der Transduktoren der ersten Gruppe ein räumlich-zeitliches Feld einer auf den Gegenstand aufzubringenden Erregung betrachtet,
    - es werden Primärsignale modelliert, die, wenn auf die erste Transduktorengruppe aufgebracht, die Erzeugung des genannten räumlich-zeitlichen Erregungsfelds ermöglichen würden,
    - es wird die genannte, mindestens eine Übertragungsfunktion auf diese Primärsignale derart aufgebracht, dass Sekundärsignale erzeugt werden,
    - es wird eine Methode der sogenannten Zeitumkehr im zeitlichen Bereich oder der Phasenkonjugation im Frequenzbereich auf diese Sekundärsignale derart angewendet, dass Erregungssignale bestimmt werden, und
    - es werden diese Erregungssignale auf die Transduktoren der zweiten Gruppe derart aufgebracht, dass das genannte räumlich-zeitliche Erregungsfeld am Gegenstand erzeugt wird.

**2.** Verfahren nach dem Anspruch 1, **dadurch gekennzeichnet, dass** während des Modellierungsschritts jedes Primärsignal in der Form $\alpha_j.X$ definiert wird, wo X das Frequenzspektrum eines Signals entsprechend der zu erzeugenden Zeitvariation ist, $\alpha$ ein komplexer Amplitude- und Phasen-Gewichtungsfaktor des Signals X ist und j eine Indexzahl ist, die jeden Transduktor der ersten Transduktorengruppe bezeichnet, wobei diese $\alpha$-Faktoren entsprechend der Richtwirkung, Empfangsrichtung, Polarisation und/ oder Intensität des räumlich-zeitlichen Erregungsfelds festgesetzt werden.

**3.** Verfahren nach Anspruch 1 oder 2, **dadurch gekennzeichnet, dass** die $\alpha_j$ nach einer Methode der Transduktorennetz-Synthese im ungenutzten Frequenzbereich festgesetzt werden.

**4.** Verfahren nach einem der vorhergehenden Ansprüche, **dadurch gekennzeichnet, dass** während des Schrittes zur Schätzung mindestens einer Übertragungsfunktion zwei Übertragungsfunktionen für jeweils zwei verschiedene, orthogonale Ausrichtungen des genannten mindestens einen Transduktors der ersten Transduktorengruppe bestimmt werden, wobei beide Ausrichtungen Tangenten an eine Fläche sind, die die Gesamtheit der Transduktoren der ersten Transduktorengruppe umfasst, dann bei dem Modellierungsschritt wird eine lineare Kombination aus beiden Übertragungsfunktionen entsprechend der gewünschten Polarisation der Wellenfront des genannten räumlich-zeitlichen Erregungsfelds aufgebracht.

**5.** Verfahren nach einem der Ansprüche 1-3, **dadurch gekennzeichnet, dass** während des ersten Schrittes drei Übertragungsfunktionen für jeweils drei verschiedene, orthogonale Ausrichtungen des genannten mindestens einen Transduktors der ersten Transduktorengruppe bestimmt werden; dann bei dem Modellierungsschritt wird eine lineare Kombination aus den drei Übertragungsfunktionen entsprechend der gewünschten Polarisation der Wellenfront des genannten räumlich-zeitlichen Erregungsfelds aufgebracht.

**6.** Verfahren nach einem der vorhergehenden Ansprüche, **dadurch gekennzeichnet, dass** die erste Transduktorengruppe eine Vielzahl von linear angeordneten Transduktoren umfasst.

**7.** Verfahren nach einem der Ansprüche 1-5, **dadurch gekennzeichnet, dass** die erste Transduktorengruppe eine Vielzahl von flächenartig angeordneten Transduktoren umfasst.

**8.** Verfahren nach einem der Ansprüche 1-5, **dadurch gekennzeichnet, dass** die erste Transduktorengruppe eine Vielzahl von derart angeordneten Transduktoren umfasst, dass ein Volumen um den getesteten Gegenstand gebildet wird.

**9.** Verfahren nach einem der vorhergehenden Ansprüche, **dadurch gekennzeichnet, dass** die Transduktoren der ersten Transduktorengruppe elektrooptische Sonden sind.

**10.** Verfahren nach einem der Ansprüche 1-8, **dadurch gekennzeichnet, dass** die Transduktoren der ersten Transduktorengruppe elektroakustische Sonden sind.

**11.** Verfahren nach einem der vorhergehenden Ansprüche, **dadurch gekennzeichnet, dass** während des Schritts zur Schätzung mindestens einer Übertragungsfunktion mindestens ein Transduktor der ersten Transduktorengruppe verwendet wird, welcher in verschiedene Positionen gebracht wird, eine Komponente der genannten mindestens einen Übertragungsfunktion für jede verschiedene Position festgesetzt wird.

**12.** Verfahren nach einem der vorhergehenden Ansprüche, **dadurch gekennzeichnet, dass** die genannte, mindestens eine Übertragungsfunktion im Frequenzbereich geschätzt wird, indem ein Netz-Analysator verwendet wird.

**13.** Verfahren nach einem der Ansprüche 1-11, **dadurch gekennzeichnet, dass** die genannte mindestens eine Übertragungsfunktion im Zeitbereich geschätzt wird, indem ein Generator von willkürlichen Funktionen oder Wellenformen und ein Oszilloskop verwendet werden.

**Claims**

**1.** Method for generating a spatio-temporal field in a reverberant environment in order to analyse the behaviour of an object under test placed in the reverberant environment, **characterized in that** it comprises the following steps:

- at least one transfer function between a first group of transducers comprising at least one transducer placed in the reverberant environment and a second group of transducers comprising at least one transducer also placed in the reverberant environment is estimated,
- taking account of the spatial distribution of the transducers of the first group, a spatio-temporal excitation field to be applied to the object is considered,
- primary signals which, when applied to the first group of transducers, make it possible to obtain said spatio-temporal excitation field are modelled,
- said at least one transfer function is applied to these primary signals so as to obtain secondary signals,
- a technique known as time reversal in the time domain or phase conjugation in the frequency domain is used on these secondary signals so as to determine excitation signals, and
- these excitation signals are applied to the transducers of the second group so as to obtain said spatio-temporal excitation field on the object.

**2.** Method according to claim 1, **characterized in that**, during the modelling stage, each primary signal is defined in the form of $\alpha_j.X$, where X is the frequency spectrum of a signal as a function of the time variation to be obtained; $\alpha$ is a complex amplitude and phase weighting coefficient for the signal X, and j is an index denoting each transducer of the first group of transducers, these coefficients $\alpha$ being defined as a function of the directivity, direction of arrival, polarization and/or intensity of the spatio-temporal excitation field.

**3.** Method according to claim 1 or 2, **characterized in that** the $\alpha_j$ are determined in accordance with a technique for synthesizing a network of transducers in free space.

**4.** Method according to any of the preceding claims, **characterized in that**, during the stage of estimation of at least one transfer function, two transfer functions are determined for respectively two different orthogonal orientations of said at least one transducer of the first group of transducers; the two orientations being tangent to a surface comprising all of the transducers of the first group of transducers; then, in the modelling stage, a linear combination of the two transfer functions is applied as a function of the desired polarization of the wave front of said spatio-temporal excitation field.

**5.** Method according to any one of claims 1 to 3, **characterized in that**, during the first phase, three transfer functions are determined for respectively three different orthogonal orientations of said at least one transducer of the first group of transducers; then, in the modelling stage, a linear combination of the three transfer functions is applied as a function of the desired polarization of the wave front of said spatio-temporal excitation field.

6. Method according to any one of the preceding claims, **characterized in that** the first group of transducers comprises a plurality of transducers positioned linearly.

7. Method according to any one of claims 1 to 5, **characterized in that** the first group of transducers comprises a plurality of transducers positioned in a surface fashion.

8. Method according to any one of claims 1 to 5, **characterized in that** the first group of transducers comprises a plurality of transducers positioned so as to constitute a volume around the object under test.

9. Method according to any of the preceding claims, **characterized in that** the transducers of the first group of transducers are electro-optical sensors.

10. Method according to any one of claims 1 to 8, **characterized in that** the transducers of the first group of transducers are electro-acoustic sensors.

11. Method according to any one of the preceding claims, **characterized in that**, during the stage of estimation of at least one transfer function, at least one transducer of the first group is used and moved into different positions and a component of said at least one transfer function is determined for each different position.

12. Method according to any one of the preceding claims, **characterized in that** the estimation of said at least one transfer function is obtained in the frequency domain using a network analyzer.

13. Method according to any one of claims 1 to 11, **characterized in that** the estimation of said at least one transfer function is obtained in the time domain using a function or arbitrary wave form generator and an oscilloscope.

FIG. 1

EP 2 414 850 B1

FIG. 2

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2005104473 A1
- US 4864315 A, MOHUCHY WOLODYMYR
- US 5302960 A, BOERS PETER

**Littérature non-brevet citée dans la description**

- On the Use of Reverberation Chambers to Simulate a Rician Radio Environment for the Testing of Wireless Devices. **CHRISTOPHER L HOLLOWAY et al.** IEEE TRANSACTIONS ON ANTENNAS AND PROPAGATION. IEEE SERVICE CENTER, 01 Novembre 2006, vol. 54, 3167-3177